# EUROPÄISCHE PATENTSCHRIFT

(11) **EP 1 930 954 B1**
(45) Veröffentlichungstag und Bekanntmachung des Hinweises auf die Patenterteilung: **29.07.2009**
(21) Anmeldenummer: 06025105.5
(22) Anmeldetag: 05.12.2006
(51) Int. Cl.: H01L 31/05, H01L 31/042, H01L 31/02, H01L 25/04

(54) **Photovoltaisches Modul und dessen Verwendung**
Photovoltaic module and its application
Module photovoltaïque et son application

(43) Veröffentlichungstag der Anmeldung: 11.06.2008
(73) Patentinhaber: Fraunhofer-Gesellschaft zur Förderung der angewandten Forschung e.V., 80686 München (DE)
(72) Erfinder: Bett, Andreas, Dr., 79114 Freiburg (DE); Jaus, Joachim, 79098 Freiburg (DE)
(74) Vertreter: Pfenning, Meinig & Partner GbR

(56) Entgegenhaltungen:
- EP-A- 1 258 925
- EP-A2- 0 535 614
- US-A1- 2004 089 338
- US-B1- 6 248 948

## Beschreibung

Die vorliegende Erfindung betrifft ein photovoltaisches Modul, das sich durch eine spezielle serielle Verschaltung von Solarzellen auf einem Trägersubstrat auszeichnet. Um dies zu ermöglichen, muss eine isolierende Schicht vorhanden sein, die im Falle der Erfindung durch eine Diode realisiert wird. Im Photovoltaikmodul dient diese Diode gleichzeitig als Schutz- oder Bypassdiode. Somit werden in diesem Falle zwei Funktionen in einem System integriert, was zu erheblichen Kostenvorteilen führt.

In der Photovoltaik werden üblicherweise mehrere Solarzellen zu größeren Einheiten (Arrays, Modulen) zusammengefasst. Innerhalb eines Arrays sind dabei mehrere Solarzellen entweder parallel oder seriell miteinander verschaltet. Dazu ist eine elektrische leitfähige Verbindung von einer zur nächsten Solarzelle notwendig. Es ist im Stand der Technik auch bekannt, in Modulen oder Arrays Bypassdioden zum Schutz der Solarzellen einzusetzen. Dies ist notwendig, da es vorkommen kann, dass einzelne Solarzellen in einem Modul mit einer Spannung im Sperrbereich belastet werden, die zur Zerstörung dieser Solarzellen führen würde.

Ein Spezialgebiet der Photovoltaik ist die sog. "Konzentrator-Photovoltaik", bei der durch ein optisches System (z.B. Linse, Spiegel) das Sonnenlicht konzentriert wird und der konzentrierte Lichtstrahl auf eine - je nach Anlagenart - relativ kleine Solarzelle trifft. Aufgrund der Lichtkonzentration entsteht lokal Wärme, die abgeführt werden muss. Je nach System erfolgt dies passiv oder durch aktive Kühlung, z.B. mittels Wasser.

Der Stand der Technik zur seriellen Verschaltung von Solarzellen in einem derartigen Konzentratormodul wird von J. Jaus beschrieben (J. Jaus, U. Fleischfresser, G. Peharz, F. Dimroth, H. Lerchenmüller, A.W. Bett, "HEAT SINK-SUBSTRATES FOR AUTOMATED AS-SEMBLY OF CONCENTRATOR-MODULES", Proc. of 21st European Photovoltaic Conference and Exhibition, Dresden, September 2006, to be published). In dieser Publikation wird die so genannte Prepreg-Technik und auch der Einsatz von Kupferplättchen mit vergoldeten Leiterplatten ausführlich dargestellt. Diese bekannte Technik weist jedoch die folgenden Nachteile auf:
- Es ist je nach Technologie eine größere Anzahl von einzelnen Teilen notwendig, für die Kosten bei der Beschaffung sowie bei der Lagerung und Fertigungslogistik entstehen.
- Bei der Montage der einzelnen Teile fallen vielerlei Arbeitsschritte "Vorbereitung der Oberflächen", "Auftragen von Verbindungsmaterialien (Kleber, Lot)", "Teil greifen und positionieren", "Aushärten der Klebeschichten" bzw. "Durchführung Lötprozess" an, häufig auch noch weitere prozessbegleitende Schritte.
- Diese Vielzahl an Arbeitsschritten erhöht die Taktzeiten, erniedrigt den Durchsatz der Fertigungslinie, und erhöht den Materialaufwand. Dadurch werden letztlich hohe Kosten verursacht.
- Einzelne Schritte, wie z.B. das Kontaktieren der einzelnen Solarzellenchips, verursachen hohe Prozesskosten (Lötprozess) und Handlingkosten.
- Die Prepreg-Technologie erweist sich in der Praxis als fehleranfällig: Bei der Herstellung entstehen Grate die zu Kurzschlüssen führen können. Dies macht aufwändige Tests notwendig und die einzelnen Prepregs vergleichsweise teuer.

Photovoltaikmodule müssen jedoch kostengünstig hergestellt werden. Um niedrige Kosten realisieren zu können, muss die Anzahl der zu montierenden Bauteile gering sein und zugleich sollten die Bauteile selbst kostengünstig sein. Insbesondere die Übernahme von mehreren Funktionalitäten in einem Bauelement hilft Kosten zu reduzieren.

Aufgabe der vorliegenden Erfindung ist es deshalb, ein Photovoltaikmodul anzugeben, das einfach und kostengünstig im Aufbau ist und das gleichzeitig bei serieller Verschaltung einen sicheren Betrieb ermöglicht.

Diese Aufgabe wird durch das photovoltaische Modul mit den Merkmalen des Anspruchs 1 gelöst. Dabei stellen die abhängigen Ansprüche bevorzugte Ausführungsformen dar. Mit Anspruch 19 werden Verwendungsmöglichkeiten genannt.

Erfindungsgemäß wird ein photovoltaisches Modul vorgeschlagen, das mindestens zwei miteinander verschaltete, auf einem elektrisch isolierenden Grundkörper angeordnete Bauzellengruppen (SCA) umfasst, die jeweils eine auf einem leitfähigen Träger aufgebrachte Solarzelle und eine dazu beabstandet aufgebrachte Bypass-Diode aufweisen, die über einen elektrischen Leiter miteinander kontaktiert sind, bei dem die Bypass-Diode eine zur Solarzelle umgekehrte Polarität aufweist und die Solarzelle und die Bypass-Diode über eine leitfähige Verbindungsschicht auf den leitfähigen Träger aufgebracht sind, wobei die Bypass-Diode eine pn-Halbleiterdiode aus Silicium ist.

Das erfindungsgemäße Modul ermöglicht es, durch sein spezielles Design mehrere Funktionen zu übernehmen, für welche nach dem Stand der Technik mehrere verschiedene Bauteile benötigt werden.

Dadurch ergeben sich vielerlei Vorteile, wie z.B.:
- Geringerer Logistikaufwand in der Arbeitsvorbereitung, Lagerhaltung und Montage,
- Geringerer Materialeinsatz,
- Geringerer maschineller und personeller Aufwand,
- Geringere Kosten.

In realen Konzentrator-Systemen, wie z.B. dem FLAT-CON-System (siehe Publikation von J. Jaus) wird die Wärme über metallische Kühlkörper abgeleitet. Für die Montage der Solarzelle muss dabei die Rückseite und der Vorderseitenkontakt voneinander isoliert kontaktiert werden, um einen Kurzschluss der Solarzelle zu vermeiden. Dazu wird eine elektrisch nicht leitende Zwischenschicht eingesetzt, die aber den Wärmetransport nicht einschränken soll.

Das erfindungsgemäße Modul zeichnet sich nun dadurch aus, dass es sowohl eine durch Bypassdioden geschützte Verschaltung der Zellen zu einem Array als auch einen optimalen Wärmetransport erlaubt. Grundsätzlich ist damit der Einsatz des erfindungsgemäßen Moduls in jedem System möglich, bei dem eine elektrische Verschaltung mit gleichzeitig guter Wärmeabfuhr notwendig ist (z.B. auch in Satellitenarrays).

Beim erfindungsgemäßen Modul ist dabei der elektrisch leitfähige Träger der SCA bevorzugt ein flächiger Träger aus Kupfer, einer Kupfer enthaltenden Legierung, verzinktem Stahl und/oder Aluminium. Dabei ist es günstig, wenn der leitfähige Träger eine Dicke von 20 bis 1000 µm aufweist.

Weiterhin ist die leitfähige Verbindungsschicht bevorzugt aus einem Lot und/oder Leitkleber gebildet. Die Erfindung umfasst aber auch alle im Stand der Technik bekannten Möglichkeiten zur Herstellung von leitfähigen Verbindungen.

Eine weitere vorteilhafte Ausführungsform sieht vor, dass auf dem leitfähigen Träger, mindestens im Bereich der Bypass-Diode und/oder der Solarzelle, eine Gold-, Nickel-, Titan- und/oder Palladiumschicht aufgebracht ist.

Der Vorteil dieser Ausführungsform ist darin zu sehen, dass dadurch das Kontaktieren mit dem jeweiligen Leiter verbessert wird. Die vorstehend beschriebene zusätzliche Beschichtung kann deshalb auch noch auf dem Bereich des Träger aufgebracht sein, bei dem der Leiter der Bypassdiode auf der nächsten SCA kontaktiert ist.

Als Solarzelle kann bei der Erfindung eine beliebige Solarzelle, bevorzugt jedoch eine III-V Halbleiter-oder Si-Solarzelle eingesetzt werden. Bevorzugt sind dabei, wie im Stand der Technik bekannt, monolithische Solarzellen. Die Erfindung umfasst dabei auch Mehrfachzellen.

Ebenso können alle aus dem Stand der Technik bekannten Dioden zur Ausführung der Erfindung verwendet werden. Vorteilhafte Dioden für Bypass-Dioden sind flächige pn-Halbleiter-Dioden.

Bevorzugt besteht dabei die Oberfläche der Diode aus einer Gold-, Nickel-, Silber-, Titan-, Palladium-und/oder Aluminium-Schicht.

Insbesondere ist es von Vorteil, wenn der die Solarzelle und die Bypass-Diode verbindende Leiter ein Draht aus Gold, Aluminium oder Kupfer ist, wobei das Aluminium noch 0 bis 2 Gew.-% Silicium und/oder 0 bis 2 Gew.-% Magnesium enthalten kann.

Erfindungswesentlich ist weiterhin, dass die Verschaltung der mindestens zwei SCAs durch einen Leiter, der von der Bypass-Diode der ersten SCA zum leitfähigen Träger der zweiten SCA führt, erfolgt. Der Leiter ist dabei wiederum insbesondere ein Draht, aus Gold, Aluminium oder Kupfer, wobei das Aluminium 0 bis 2 Gew.-% Silicium und/oder 0 bis 2 Gew.-% Magnesium enthalten kann.

Bezüglich der geometrischen Anordnung der Solarzelle auf dem leitfähigen Träger ist jede beliebige Position möglich, besonders günstig ist es, wenn die Solarzelle im Wesentlichen mittig auf dem metallischen Träger angeordnet ist.

Ebenso ist der metallische Träger auf keine spezielle Ausführungsform beschränkt. Bevorzugt ist der metallische Träger vieleckig, bevorzugt rechteckig. Weitere bevorzugte Formen sind beispielsweise hexagonale Strukturen, die wie die vier- bzw. rechteckigen Ausführungsformen eine platzsparende Anordnung ermöglichen.

Die Bypass-Diode kann überall auf dem metallischen Träger angeordnet sein. Bevorzugt ist die Bypassdiode in der näheren Umgebung der Solarzelle angeordnet. Der Abstand zur Solarzelle kann z.B. zwischen 0,5 und 50 mm, bevorzugt zwischen 1 und 10 mm liegen.

Prinzipiell können beliebig viele, maximal bis zu 1000, SCAs seriell miteinander verschaltet werden. Bevorzugt werden 40 bis 200 Zellen verschaltet.

Der isolierende Grundkörper kann aus jedem beliebigen isolierenden Material gefertigt sein. Vorzugsweise werden die Materialien ausgewählt aus einer Glasplatte oder eine mit einer isolierenden, dielektrischen Schicht beschichtete Metallplatte. Die Schichtdicke der isolierenden, dielektrischen Schicht beträgt dabei bevorzugt von 0,05 bis 0,1 mm, während der isolierende Grundkörper bevorzugt 0,1 bis 5 mm dick ist.

Erfindungsgemäß kommen die photovoltaischen Module insbesondere in hochkonzentrierten Photovoltaikmodulen zum Einsatz.

Wie vorstehend beschrieben, zeichnet sich das erfindungsgemäße Modul dadurch aus, dass nur einfache und kostengünstige Bauelemente benötigt werden, wie Kupferplättchen, eine flächig kontaktierte Diode und die Solarzelle. Die Besonderheit der Erfindung liegt darin, dass die in einer Modulverschaltung notwendige Bypassdiode die Funktionalität einer isolierenden Kontaktschicht mit gleichzeitig hervorragender Wärmeleitung übernimmt. Diese Eigenschaft verhindert ein Verkohlen des Kontaktpads auf Basis von Leiterplattenmaterial, wie es in Feldversuchen beobachtet wurde. Dies ist eine Folge einer "off-point" Stellung des Moduls auf der Nachführeinheit. In diesem Falle (einer Fehlfunktion des Systems) wird das Licht nicht auf die Solarzelle, sondern an eine undefinierte Stelle im Modul fokussiert. Diese Fehlfunktion kann in der Realität vorkommen und wird daher auch in der IEC-Norm "IEC 62108 Draft 8d: Concentrator Photovoltaic (CPV) Modules and Assemblies - Design Qualification and Type Approval" geprüft. Der fokussierte Lichtstrahl kann z.B. auf die Schnittkante einer Leiterplatine fallen. Aufgrund der hohen Energiedichte kommt es dann zu einem Verbrennen des organischen Materials der Leiterplatine, was die Funktionalität als isolierende Schicht beeinträchtigt. Dient die Bypass-diode als Kontaktpad, sind keine organischen Stoffe vorhanden und die Wärme wird durch die Si-Diode sehr gut abgeleitet. Die Fehleranfälligkeit wird somit deutlich gesenkt. Weiterhin kann die Leiterplatine selbst eingespart werden, was weitere Kosten senkt.

Der Erfindungsgegenstand ermöglicht somit den Aufbau einer Baugruppe basierend auf einer einfachen Kupferplatte. Im Vergleich zur Prepreg-Technologie, wie sie bei der Beschreibung des Standes der Technik dargestellt wurde, wird mit dem erfindungsgemäßen Aufbau eine kostengünstigere Realisierung der Verschaltung ermöglicht. Im Folgenden sind die Vorteile des erfindungsgemäßen Moduls zusammengefasst.
- Die elektrische Kontaktierung der Rückseite der Solarzelle direkt auf dem Kühlköper erlaubt eine gute thermische Anbindung.
- Der Vorderseitenkontakt der Solarzellen wird auf die flächig kontaktierte Bypassdiode geführt.
- Der Rückkontakt der Bypassdiode wird direkt auf die Kupferplatte kontaktiert, was eine gute thermische Ableitung der Wärme ermöglicht.
- Die elektrisch isolierende Funktion wird durch den pn-Übergang der Bypassdiode gewährleistet - es werden keine organische Materialen eingesetzt.
- Es wird die kleinstmögliche Zahl der Komponenten für die Herstellung der Solarzellenbaugruppe verwendet, was zu einem hohen Durchsatz in der Fertigung führt.
- Bei einer Fehlfunktion im System (off-pointing) bleibt die Funktionalität erhalten - die Fehleranfälligkeit des Konzentratorsystems wird reduziert.

Die erfindungsgemäße Lösung ermöglicht es somit, mehrere dieser Funktionen in einem Bauteil zu integrieren, wodurch sich die bei einer Integration üblichen (Kosten-)vorteile (weniger Prozessschritte, geringerer Materialeinsatz, etc.) ergeben.

Vorliegende Erfindung wird anhand der beigefügten Figuren näher erläutert, ohne die Erfindung auf die speziellen Merkmale beschränken zu wollen.

Dabei zeigen
- Fig. 1: den erfindungsgemäßen Aufbau eines photovoltaischen Moduls,
- Fig. 2: eine schematische Darstellung eines photovoltaischen Moduls mit Leiterplatten-Technologie gemäß dem Stand der Technik.

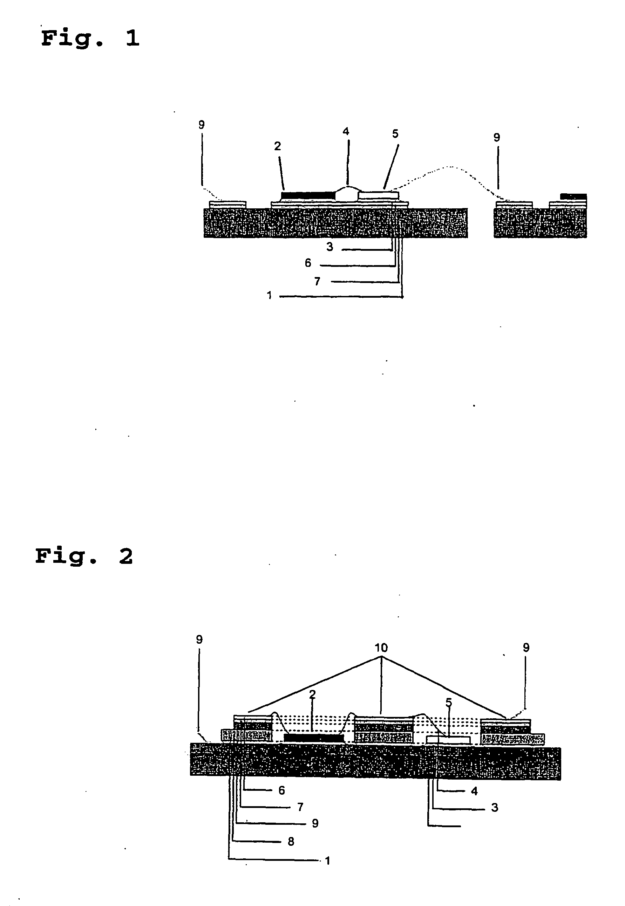

Figur 1 zeigt den typischen Aufbau einer erfindungsgemäßen Verschaltung. Auf einem Trägersubstrat 1, z.B. aus Kupfer, ist das elektrische Bauelement 2, z.B. eine Solarzelle, aufgebracht. Die Rückseite der Solarzelle 2 wird durch eine elektrisch und thermisch leitende Verbindung 3, z.B. Lot oder Silberleitkleber, verbunden. Die Vorderseite des Bauelementes wird z.B. durch Bond- oder Schweißtechnologie mit einem Leiter 4 kontaktiert. Die Drahtlänge ist dabei limitiert und wird auf ein zum Trägersubstrat 1 hin isoliertes Kontaktpad 5 geführt. Für die vorliegende Erfindung besteht das Kontaktpad 5 aus einer flächigen Diode, die im Vergleich zur Solarzelle 2 eine umgekehrte Polarität besitzt. Die Gesamtheit der Elemente 1 bis 5 wird Bauzellengruppe (SCA) genannt. Bei der Ausführungsform nach Figur 1 ist zusätzlich auf dem Träger 1 eine Au/Ni-Plattinierung (6, 7) aufgebracht. Diese dient zur besseren Kontaktierung. Mehrere Bauzellengruppen (SCAs) können auf einem elektrisch isolierenden Grundkörper, z.B. einer Glasplatte, aufgebracht werden (hier nicht dargestellt). Die Bauzellengruppen (SCAs) sind von der Kontaktpad-Oberseite 5 zum nächsten Träger der SCA, z.B. durch Verlöten von Drähten 9 oder Dickdrahtbondtechnologie, verbunden. Durch diese Anordnung werden die Baugruppen (SCAs) seriell verschaltet. Innerhalb jeder Baugruppe schützt die parallel geschaltete Bypassdiode 5 als Kontaktpad die Solarzelle 2 vor einer möglichen Rückwärtsbelastung.

In Fig. 2 ist ein aus dem Stand der Technik bekannter Aufbau eines photovoltaischen Moduls abgebildet.

Hierbei ist das Trägersubstrat 1 aus einer 1 mm dicken Kupferplatte gebildet, die hauptsächlich dem Hitzetransfer sowie der elektrischen Verbindung der Rückseite der Solarzelle dient. Auf diese Kupferplatte 1 ist eine dünne Epoxidharz-imprägnierte Glasfasermatte als dielektrische Schicht 8 aufgebracht. Wiederum darauf aufgebracht ist eine Kupferfolie 9, die zur elektrischen Verbindung der Frontkontakte der Solarzelle dient. Die obere Kupferschicht 9 weist dabei noch eine Nickelschicht 7 und eine Goldschicht 6 auf. Um einen guten Hitzetransfer zu gewährleisten, ist es erforderlich, dass die Solarzelle 2 und die Bypassdiode 5 direkt auf die Kupferbasisschicht aufgebracht werden. Die thermische Kontaktierung zum elektrischen leitenden Trägersubstrat 1 erfolgt dabei wieder durch ein thermisch leitfähiges Lot 3. Im Gegensatz zu vorliegender Erfindung ist bei photovoltaischen Modulen, wie sie im Stand der Technik bekannt sind (z.B. in vorliegender Figur 2), die Solarzelle 2 nicht direkt mit der Bypassdiode 5 über einen Draht 4 verbunden, sondern die elektrische Kontaktherstellung verläuft über die auf dem Trägersubstrat 1 aufgebrachten Strukturen 10. Ebenso erfolgt die elektrische Verbindung der photovoltaischen Module untereinander über die Kontakte 9 nicht direkt ausgehend von der Bypassdiode, sondern immer indirekt über die Strukturen 10. Alles in allem ergibt sich somit ein wesentlich komplexerer Aufbau eines photovoltaischen Moduls, was sich nachteilig auf Herstellungsverfahren und Herstellungskosten auswirkt. Durch den wesentlich einfacheren Aufbau des erfindungsgemäßen photovoltaischen Moduls, wie in Figur 1 dargestellt, lassen sich diese Nachteile vermeiden.

Durch den beschriebenen Erfindungsgegenstand ist es möglich, das Fertigungsverfahren deutlich zu beschleunigen, weniger Bauteile einzusetzen und die Zuverlässigkeit deutlich zu erhöhen. Summarisch können dadurch erheblich Kosten eingespart werden.

## Patentansprüche

1. Photovoltaisches Modul, umfassend mindestens zwei miteinander verschaltete, auf einem elektrisch isolierenden Grundkörper angeordnete Bauzellengruppen (SCA), die jeweils eine auf einem thermisch und elektrisch leitfähigen Träger (1) aufgebrachte III-V-Halbleiter-Solarzelle (2) und eine dazu beabstandet aufgebrachte Bypass-Diode (5) umfassen, die über einen elektrischen Leiter miteinander kontaktiert sind,
wobei die Bypass-Diode eine zur Solarzelle umgekehrte Polarität aufweist und die Solarzelle und die Bypass-Diode über eine leitfähige Verbindungsschicht auf den leitfähigen Träger aufgebracht sind, **dadurch gekennzeichnet, dass** die Bypass-Diode eine pn-Halbleiterdiode aus Silicium ist.

2. Photovoltaisches Modul nach Anspruch 1, **dadurch gekennzeichnet, dass** der elektrisch leitfähige Träger der SCA ein flächiger Träger aus Kupfer, einer Kupfer enthaltenden Legierung, verzinktem Stahl und/oder Aluminium ist.

3. Photovoltaisches Modul nach Anspruch 2, **dadurch gekennzeichnet, dass** der leitfähige Träger eine Dicke von 20 bis 1000 µm aufweist.

4. Photovoltaisches Modul nach mindestens einem der Ansprüche 1 bis 3, **dadurch gekennzeichnet, dass** die leitfähige Verbindungsschicht aus einem Lot und/oder Leitkleber gebildet ist.

5. Photovoltaisches Modul nach mindestens einem der Ansprüche 1 bis 4, **dadurch gekennzeichnet, dass** auf dem leitfähigen Träger, mindestens im Bereich der Bypass-Diode und/oder der Solarzelle, eine Gold-, Nickel-, Titan- und/oder Palladiumschicht aufgebracht ist.

6. Photovoltaisches Modul nach einem der vorhergehenden Ansprüche, **dadurch gekennzeichnet, dass** die Solarzelle eine monolithische Solarzelle ist.

7. Photovoltaisches Modul nach mindestens einem der Ansprüche 1 bis 6, **dadurch gekennzeichnet, dass** die Bypass-Diode eine flächige pn-HalbleiterDiode ist.

8. Photovoltaisches Modul nach mindestens einem der Ansprüche 1 bis 7, **dadurch gekennzeichnet, dass** die Oberfläche der Diode eine Gold-, Nickel-, Silber-, Titan-, Palladium- und/oder Aluminium-Oberfläche ist.

9. Photovoltaisches Modul nach mindestens einem der Ansprüche 1 bis 8, **dadurch gekennzeichnet, dass** der die Solarzelle und die Bypass-Diode verbindende Leiter ein Draht aus Gold, Aluminium oder Kupfer ist.

10. Photovoltaisches Modul nach mindestens einem der Ansprüche 1 bis 9, **dadurch gekennzeichnet, dass** die Verschaltung der mindestens zwei SCAs durch einen Leiter, der von der Bypass-Diode der ersten SCA zum leitfähigen Träger der zweiten SCA führt, erfolgt.

11. Photovoltaisches Modul nach Anspruch 10, **dadurch gekennzeichnet, dass** der Leiter ein Draht aus Gold, Aluminium oder Kupfer ist.

12. Photovoltaisches Modul nach einem der Ansprüche 9 bis 11, **dadurch gekennzeichnet, dass** der Leiter ein Draht aus Aluminium mit 0 bis 2 Gew.-% Si und/oder 0 bis 2 Gew.-% Mg ist.

13. Photovoltaisches Modul nach mindestens einem der Ansprüche 1 bis 12, **dadurch gekennzeichnet, dass** die Solarzelle im Wesentlichen mittig auf dem metallischen Träger angeordnet ist.

14. Photovoltaisches Modul nach Anspruch 13, **dadurch gekennzeichnet, dass** der metallische Träger vieleckig, bevorzugt rechteckig ist.

15. Photovoltaisches Modul nach mindestens einem der Ansprüche 1 bis 14, **dadurch gekennzeichnet, dass** zwei bis 1000 SCA's seriell verschaltet sind.

16. Photovoltaisches Modul nach mindestens einem der Ansprüche 1 bis 15, **dadurch gekennzeichnet, dass** der isolierende Grundkörper eine Glasplatte oder eine mit einer isolierenden, dielektrischen Schicht beschichtete Metallplatte ist.

17. Photovoltaisches Modul nach vorhergehendem Anspruch, **dadurch gekennzeichnet, dass** die Schichtdicke der isolierenden, dielektrischen Schicht 0,05 bis 0,1 mm beträgt.

18. Photovoltaisches Modul nach mindestens einem der Ansprüche 1 bis 17, **dadurch gekennzeichnet, dass** der isolierende Grundkörper 0,1 bis 5 mm dick ist.

19. Verwendung des photovoltaischen Moduls nach mindestens einem der Ansprüche 1 bis 18 in hochkonzentrierten Photovoltaikmodulen.

## Claims

1. Photovoltaic module, comprising at least two interconnected structural cell assemblies (SCA) which are arranged on an electrically insulating base body and each comprise a III-V semiconductor solar cell (2) applied on a thermally and electrically conductive carrier (1) and a bypass diode (5) applied at a distance from said solar cell, which are contact-connected to one another by means of an electrical conductor,
wherein the bypass diode has a polarity opposite to that of the solar cell and the solar cell and the bypass diode are applied to the conductive carrier by means of a conductive connecting layer, **characterized in that** the bypass diode is a pn semiconductor diode composed of silicon.

2. Photovoltaic module according to Claim 1, **characterized in that** the electrically conductive carrier of the SCA is a planar carrier composed of copper, a copper-containing alloy, galvanized steel and/or aluminium.

3. Photovoltaic module according to Claim 2, **characterized in that** the conductive carrier has a thickness of 20 to 1000 µm.

4. Photovoltaic module according to at least one of Claims 1 to 3, **characterized in that** the conductive connecting layer is formed from a solder and/or conductive adhesive.

5. Photovoltaic module according to at least one of Claims 1 to 4, **characterized in that** a gold, nickel, titanium and/or palladium layer is applied on the conductive carrier, at least in the region of the bypass diode and/or of the solar cell.

6. Photovoltaic module according to any of the preceding claims, **characterized in that** the solar cell is a monolithic solar cell.

7. Photovoltaic module according to at least one of Claims 1 to 6, **characterized in that** the bypass diode is a planar pn semiconductor diode.

8. Photovoltaic module according to at least one of Claims 1 to 7, **characterized in that** the surface of the diode is a gold, nickel, silver, titanium, palladium and/or aluminium surface.

9. Photovoltaic module according to at least one of Claims 1 to 8, **characterized in that** the conductor that connects the solar cell and the bypass diode is a wire composed of gold, aluminium or copper.

10. Photovoltaic module according to at least one of Claims 1 to 9, **characterized in that** the at least two SCAs are interconnected by a conductor that leads from the bypass diode of the first SCA to the conductive carrier of the second SCA.

11. Photovoltaic module according to Claim 10, **characterized in that** the conductor is a wire composed of gold, aluminium or copper.

12. Photovoltaic module according to any of Claims 9 to 11, **characterized in that** the conductor is a wire composed of aluminium comprising 0 to 2% by weight of Si and/or 0 to 2% by weight of Mg.

13. Photovoltaic module according to at least one of Claims 1 to 12, **characterized in that** the solar cell is arranged substantially centrally on the metallic carrier.

14. Photovoltaic module according to Claim 13, **characterized in that** the metallic carrier is polygonal, preferably rectangular.

15. Photovoltaic module according to at least one of Claims 1 to 14, **characterized in that** two to 1000 SCAs are interconnected in series.

16. Photovoltaic module according to at least one of Claims 1 to 15, **characterized in that** the insulating base body is a glass plate or a metal plate coated with an insulating, dielectric layer.

17. Photovoltaic module according to the preceding claim, **characterized in that** the layer thickness of the insulating, dielectric layer is 0.05 to 0.1 mm.

18. Photovoltaic module according to at least one of Claims 1 to 17, **characterized in that** the insulating base body is 0.1 to 5 mm thick.

19. Use of the photovoltaic module according to at least one of Claims 1 to 18 in highly concentrated photovoltaic modules.

## Revendications

1. Module photovoltaïque, comprenant au moins deux groupes de structures cellulaires (SCA) reliés l'un avec l'autre et disposés sur un corps de base isolant électriquement, lesquels comprennent des cellules solaires semiconductrices III-V (2) placées sur un support (1) conducteur thermiquement et électriquement et une diode bypass (5) placée à distance, lesquelles entrent en contact les unes avec les autres via un conducteur électrique,
la diode bypass présentant une polarité inversée par rapport aux cellules solaires et les cellules solaires et la diode bypass étant placées sur le support conducteur via une couche de liaison conductrice, **caractérisé en ce que** la diode bypass est une diode semi-conductrice PN en silicium.

2. Module photovoltaïque selon la revendication 1, **caractérisé en ce que** le support conducteur électrique des SCA est un support plat en cuivre, est composé d'un alliage contenant du cuivre, est en acier galvanisé et/ou en aluminium.

3. Module photovoltaïque selon la revendication 2, **caractérisé en ce que** le support conducteur comporte une épaisseur comprise entre 20 et 1000 µm.

4. Module photovoltaïque selon au moins l'une quelconque des revendications 1 à 3, **caractérisé en ce que** la couche de liaison conductrice est formée d'un alliage d'apport et/ou d'une colle conductrice.

5. Module photovoltaïque selon au moins l'une quelconque des revendications 1 à 4, **caractérisé en ce que**, sur le support conducteur, une couche d'or, de nickel, de titane et/ou de palladium est disposée au moins dans la région de la diode bypass et/ou de la cellule solaire.

6. Module photovoltaïque selon l'une quelconque des revendications précédentes, **caractérisé en ce que** la cellule solaire est une cellule solaire monolithique.

7. Module photovoltaïque selon au moins l'une quelconque des revendications 1 à 6, **caractérisé en ce que** la diode bypass est une diode semi-conductrice PN plane.

8. Module photovoltaïque selon au moins l'une quelconque des revendications 1 à 7, **caractérisé en ce que** la surface de la diode est une surface en or, en nickel, en argent, en titane, en palladium et/ou en aluminium.

9. Module photovoltaïque selon au moins l'une quelconque des revendications 1 à 8, **caractérisé en ce que** le conducteur reliant la cellule solaire et la diode bypass est un fil en or, en aluminium ou en cuivre.

10. Module photovoltaïque selon au moins l'une quelconque des revendications 1 à 9, **caractérisé en ce que** le câblage de deux SCA au moins est effectué par un conducteur, qui part de la diode bypass du premier SCA jusqu'au support conducteur du second SCA.

11. Module photovoltaïque selon la revendication 10, **caractérisé en ce que** le conducteur est un fil en or, en aluminium ou en cuivre.

12. Module photovoltaïque selon l'une quelconque des revendications 9 à 11, **caractérisé en ce que** le conducteur est un fil en aluminium avec un pourcentage pondéral de 0 à 2 % Si et/ou 0 à 2 % Mg.

13. Module photovoltaïque selon au moins l'une quelconque des revendications 1 à 12, **caractérisé en ce que** la cellule solaire est principalement centrée sur le support métallique.

14. Module photovoltaïque selon la revendication 13, **caractérisé en ce que** le support métallique est polygonal, de préférence rectangulaire.

15. Module photovoltaïque selon au moins l'une quelconque des revendications 1 à 14, **caractérisé en ce qu'**il est possible de brancher en série de 2 à 1000 SCA.

16. Module photovoltaïque selon au moins l'une quelconque des revendications 1 à 15, **caractérisé en ce que** le corps de base isolant est une plaque en verre ou une plaque métallique recouverte d'une couche isolante ou diélectrique.

17. Module photovoltaïque selon la revendication précédente, **caractérisé en ce que** l'épaisseur de la couche diélectrique isolante est comprise entre 0,05 mm et 0,1 mm.

18. Module photovoltaïque selon au moins l'une quelconque des revendications 1 à 17, **caractérisé en ce que** le corps de base isolant a une épaisseur comprise entre 0,1 et 5 mm.

19. Utilisation du module photovoltaïque selon au moins l'une quelconque des revendications 1 à 18 dans des modules photovoltaïques à haute concentration.
